# EUROPEAN PATENT APPLICATION

(11) **EP 4 094 948 A1**
(43) Date of publication of application: **30.11.2022**
(21) Application number: 21744811.7
(22) Date of filing: 14.01.2021
(51) Int. Cl.: B41J 2/447, B41J 2/45, G09F 9/30, H05B 33/02, H01L 51/50

(54) **LIGHT-EMITTING DEVICE**

(30) Priority: 24.01.2020 JP 2020010326
(71) Applicant: Kyocera Corporation, Kyoto-shi Kyoto 612-8501 (JP)
(72) Inventor: WATANABE, Masaya, Kyoto-shi, Kyoto 612-8501 (JP); NISHIDE, Masahiko, Kyoto-shi, Kyoto 612-8501 (JP); ARISAWA, Takashi, Kyoto-shi, Kyoto 612-8501 (JP)
(74) Representative: TBK
(86) International application number: PCT/JP2021/001109
(87) International publication number: WO 2021/149592

(57) **Abstract**

A light-emitting device includes a first connection wire and a second connection wire each connecting a first power supply wire and a second power supply wire, a second lead wire between the first connection wire and the second connection wire, and first lead wires including a first lead wire located opposite to the second lead wire from the first connection wire. The first lead wires are parallel to one another and include first connection pads as first connections at ends connected to first signal wires. The second lead wire includes a second connection pad as a second connection at an end connected to a second signal wire. A distance between the second connection pad and a first connection pad of the first connection pads adjacent to the second connection pad is greater than a distance between adjacent ones of the first connection pads.

## Description

### TECHNICAL FIELD

The present disclosure relates to a light-emitting device including light emitters such as organic light-emitting diodes (OLEDs) and organic electroluminescence (OEL) elements.

### BACKGROUND OF INVENTION

A known light-emitting device is described in, for example, Patent Literature 1.

### CITATION LIST

### PATENT LITERATURE

Patent Literature 1: Japanese Unexamined Patent Application Publication No. 2017-216150

### SUMMARY

A light-emitting device according to an aspect of the present disclosure includes a substrate, a plurality of first signal wires and a second signal wire located in a first area on the substrate and extending in a predetermined direction, a plurality of first switching elements and a plurality of first light-emitting portions connected to outputs of the plurality of first switching elements, a second switching element and a second light-emitting portion connected to an output of the second switching element, a plurality of first lead wires connected to inputs of the plurality of first switching elements, a second lead wire connected to an input of the second switching element, a plurality of first connections of the plurality of first lead wires, and a second connection of the second lead wire. The plurality of first switching elements and the plurality of first light-emitting portions are located in a second area on the substrate. The second switching element and the second light-emitting portion are located in the second area and adjacent to a first switching element of the plurality of first switching elements and a first light-emitting portion of the plurality of first light-emitting portions in the predetermined direction. The second lead wire extends in a direction intersecting with the predetermined direction. The plurality of first connections are connected to the plurality of first signal wires. The second connection is connected to the second signal wire. A distance between the second connection and a first connection of the plurality of first connections adjacent to the second connection is greater than a distance between adjacent first connections of the plurality of first connections.

A light-emitting device according to another aspect of the present disclosure includes a substrate being an elongated plate, a first power supply wire located on the substrate and extending parallel to a longitudinal direction of the substrate, a second power supply wire located on the substrate and extending parallel to the first power supply wire, a plurality of first signal wires located in a first area between the first power supply wire and the second power supply wire on the substrate, a plurality of first switching elements and a plurality of first light-emitting portions connected to the plurality of first switching elements, a second switching element and a second light-emitting portion connected to the second switching element, a second signal wire located between the plurality of first signal wires in the first area and the first power supply wire, a first connection wire connecting the first power supply wire and the second power supply wire, a plurality of first lead wires located on the substrate and including a first lead wire adjacent to the first connection wire in the longitudinal direction, and a second lead wire located on the substrate and opposite to the first lead wire adjacent to the first connection wire from the first connection wire in the longitudinal direction. The plurality of first signal wires extend parallel to the first power supply wire. The plurality of first switching elements and the plurality of first light-emitting portions are located in a second area on the substrate. The second area is located opposite to the first area from the second power supply wire. The second switching element and the second light-emitting portion are located in the second area and adjacent to a first switching element of the plurality of first switching elements and a first light-emitting portion of the plurality of first light-emitting portions in the longitudinal direction. The plurality of first lead wires connect the plurality of first signal wires and the plurality of first switching elements. The second lead wire connects the second signal wire and the second switching element. The plurality of first lead wires are located parallel to one another. The plurality of first lead wires include a plurality of first connections at ends connected to the plurality of first signal wires. The second lead wire includes a second connection at an end connected to the second signal wire. A distance between the second connection and a first connection of the plurality of first connections adjacent to the second connection is greater than a distance between adj acent first connections of a plurality of the first connections.

### BRIEF DESCRIPTION OF THE DRAWINGS

The objects, features, and advantages of the present disclosure will become more apparent from the following detailed description and the drawings.
FIG. 1 is a partial schematic plan view of a light-emitting device according to one embodiment of the present disclosure.
FIG. 2 is a schematic plan view of the light-emitting device illustrating its overall structure.
FIG. 3 is a circuit diagram of part III in FIG. 2 and a driver.
FIG. 4 is an enlarged partial plan view of the light-emitting portions in a part of FIG. 2, switching elements connected to the light-emitting portions, and wires connected to the switching elements.
FIG. 5 is a cross-sectional view taken along line V1-V2 in FIG. 4.
FIG. 6 is a cross-sectional view taken along line V3-V4 in FIG. 1.
FIG. 7 is an enlarged partial plan view of the light-emitting device illustrating its wiring structure.
FIG. 8 is an enlarged partial plan view of a light-emitting device according to another embodiment of the present disclosure illustrating its wiring structure.
FIG. 9 is an enlarged partial plan view of a light-emitting device according to another embodiment of the present disclosure illustrating its wiring structure.
FIG. 10 is an enlarged partial plan view of a light-emitting device according to another embodiment of the present disclosure illustrating its wiring structure.

### DESCRIPTION OF EMBODIMENTS

The structure that forms the basis of a display device according to one or more embodiments of the present disclosure will be described first.

A light-emitting device described in Patent Literature 1, for example, includes an elongated plate substrate, such as a glass substrate, having one surface including multiple light emitters aligned in the longitudinal direction of the substrate, multiple drive circuit blocks for driving the respective light emitters, and multiple wires connecting the drive circuit blocks and the light emitters. The multiple wires include data wires connecting a driver and the drive circuit blocks. The drive circuit blocks are aligned along the multiple light emitters aligned in line. For example, one drive circuit block may drive 400 light emitters. Twenty of the drive circuit blocks may be each connected, with the wires described above, to the light emitters. The light-emitting device thus includes 8000 light emitters in total.

The substrate includes one end in the longitudinal direction including a drive device, which drives each drive circuit block and each light emitter to control illumination of each light emitter that is mounted with a mounting method such as chip on glass (COG). The substrate has one surface including a flexible printed circuit board (FPC) for inputs and outputs of driving signals, control signals, or other signals between the drivers located at the periphery near the installation position of each driver.

Each drive circuit includes a shift register, a negated OR (NOR) circuit, an inverter, a complementary metal-oxide semiconductor (CMOS) transfer gate, and drive thin film transistors (TFTs). The drive TFTs each include a drain electrode connected to the light emitter including an organic light-emitting diode (LED) or another device. When a gate electrode of each drive TFT receives a gate potential from the corresponding wire as a data signal, a power supply current generated by a power supply voltage corresponding to the data signal is supplied to the corresponding light emitter, which then emits light with different luminance.

The display device described in Patent Literature 1 includes a multilayer stacked wiring structure including various wires between multiple insulating layers on the substrate. The multilayer stacked wiring structure includes a lower-layer gate potential supply wire, which is to be connected to the gate electrode in the corresponding drive TFT and extending parallel to the longitudinal direction of the substrate until reaching a light-emitting point at which the corresponding light emitter is located. The lower-layer gate potential supply wire is then connected to an upper-layer gate potential supply wire through an interlayer connection conductor such as a contact hole. Each upper-layer gate potential supply wire extends perpendicular to the longitudinal direction of the substrate to connect to the gate electrode in the corresponding drive TFT. The upper-layer gate potential supply wire extends perpendicular to the longitudinal direction of the substrate across other multiple lower-layer gate potential supply wires extending parallel to the longitudinal direction of the substrate, and connects to the gate electrode in the corresponding drive TFT. This wiring path has parasitic capacitance between one upper-layer gate potential supply wire and each of the multiple other lower-layer gate potential supply wires. A different gate potential is fed to the gate electrode of each drive TFT due to the parasitic capacitance.

Each upper-layer gate potential supply wire is connected to the corresponding interlayer connection conductor at a connection. Each connection and the corresponding light-emitting point are spaced gradually farther (or gradually nearer) from each other over a proximal light-emitting point nearest a power supply at the longitudinal end of the substrate to a distal light-emitting point far from the power supply. The parasitic capacitance also increases gradually over an upper-layer gate potential supply wire including the connection nearest the corresponding light-emitting point to an upper-layer gate potential supply wire including the connection farthest from the corresponding light-emitting point, causing gradient distributions of parasitic capacitance over the light-emitting points. Thus, the multiple light-emitting points emit light with the gradient luminance varied in the longitudinal direction. Thus, light-emitting devices with no gradient distributions of parasitic capacitance and less varied luminance have been awaited.

The source electrode of each drive TFT is connected to a power supply wire (anode wire or VDD wire) located parallel to the multiple lower-layer gate potential supply wires in a plan view. The power supply wire may be located outside (farther from the light-emitting points) and inside (nearer the light-emitting points) of the multiple lower-layer gate potential supply wires, and is located at least outside. The power supply wire branches into power supply branch wires, and one of the power supply branch wires is located through a space (space Ss) between the connections of adjacent upper-layer gate potential supply wires and a space (space Sh) between the upper-layer gate potential supply wires. The power supply branch wire is then connected to the source electrode. The spaces Ss and Sh are small. The space Ss is particularly small, with the adjacent connections are close to each other. Thus, the power supply branch wire is more likely to come into contact with its adjacent upper-layer gate potential supply wires and be short-circuited. A thinner power supply branch wire to avoid short-circuiting is likely to cause an insufficient power supply voltage (source voltage) fed to the drive TFTs.

A light-emitting device according to one or more embodiments of the present disclosure will now be described with reference to the accompanying drawings.

### First Embodiment

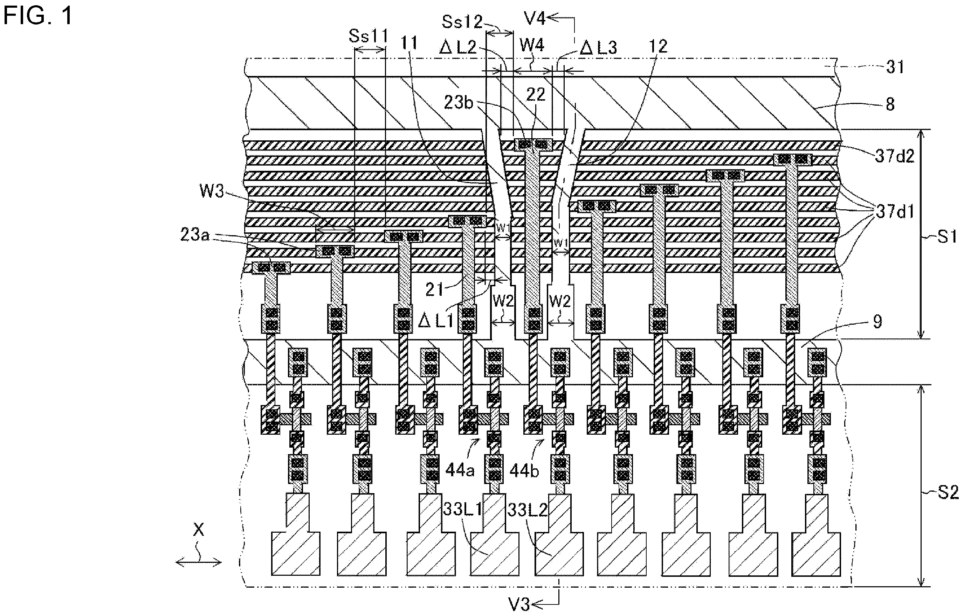

FIG. 1 is a partial schematic plan view of a light-emitting device according to one embodiment of the present disclosure. The present embodiment describes, as an example, the light-emitting device used in an organic light-emitting diode printer (OLEDP) head that forms image information as electrostatic latent images on a surface of a photosensitive drum in an image forming device. The OLEDP head includes an elongated plate substrate including 8000 to 16000 light emitters aligned in a straight line with substantially uniform circuit patterns. A basic circuit pattern in the light-emitting device according to one or more embodiments of the present disclosure is described with reference to FIG. 1.

In the present embodiment, the light-emitting device includes a substrate 31, first signal wires 37d1 and a second signal wire 37d2 located in a first area S1 on the substrate 31 and extending along a predetermined direction (e.g., the longitudinal direction X of the substrate 31), TFTs 44a as first switching elements located in a second area S2 on the substrate 31, first light-emitting portions 33L1 connected to outputs of the TFTs 44a, a TFT 44b as a second switching element located in the second area S2 and adjacent to the TFTs 44a and the first light-emitting portions 33L1 in the predetermined direction, a second light-emitting portion 33L2 connected to an output of the TFT 44b, multiple first lead wires 21 each connected to an input (gate electrode) of the corresponding TFT 44a and extending in a direction intersecting with the predetermined direction (e.g., lateral direction of the substrate 31), a second lead wire 22 connected to an input of the TFT 44b and extending in the direction intersecting with the predetermined direction, first connection pads 23a as first connections of the first lead wires 21 connected to the first signal wires 37d1, and a second connection pad 23b as a second connection of the second lead wire 22 connected to the second signal wire 37d2. The distance between the second connection pad 23b and its adjacent first connection pad 23a is greater than the distance between adjacent ones of the first connection pads 23a.

In the present embodiment, the light-emitting device with the above structure produces the effects described below. A space (space Ss12) between the second connection pad 23b and its adjacent first connection pad 23a is larger than a space (Ss11) between adjacent one of the first connection pads 23a. The spaces Ss11 and Ss12 each correspond to the distance (shortest distance) between the connection pads spaced from each other, and are different from distances in the longitudinal direction X. When Ss12 > Ss11, placing another wire such as a power supply branch wire through the space Ss12 is easier. This allows complex wiring structure in a space with a limited area. This also allows another wire such as a power supply branch wire placed through the space Ss12 to have a greater width, thus lowering the resistance of the other wire.

The predetermined direction on the substrate 31 may be, for an elongated substrate 31, the longitudinal direction X of the substrate 31. When the substrate 31 is square or in another shape without a clear longitudinal direction, the predetermined direction may be parallel to one side of the substrate 31. The direction intersecting with the predetermined direction may be, for the elongated substrate 31, the lateral direction of the substrate 31. When the substrate 31 is square or in another shape without a clear longitudinal direction, the direction intersecting with the predetermined direction may be substantially orthogonal to the predetermined direction. The angle of intersection between the predetermined direction and the direction intersecting with the predetermined direction may be about 45 to 90°, or more specifically, about 80 to 90°. A range of values referred to herein as one value to another value intends to mean the two values being inclusive.

The second signal wire 37d2 may be located farther from the second area S2 than any of the first signal wires 37d1 to allow the second lead wire 22 to be longer than any of the first lead wires 21. This structure easily achieves Ss12 > Ss11. The value of Ss12 may be greater than Ss11 and may be about five times Ss11 or less. For example, Ss11 may be about 5 to 50 µm.

As illustrated in FIG. 1, the light-emitting device may include multiple first signal wires 37d1 parallel to one another. One first connection pad 23a may be connected to one first signal wire 37d1, and another first connection pad 23a adjacent to the first connection pad 23a described above may be connected to another first signal wire 37d1 adjacent to the first signal wire 37d1 described above. This structure has a smaller value of Ss11, thus easily achieving Ss12> Ss11.

The light-emitting device may include a first power supply wire 8 and a second power supply wire 9 located on the substrate 31 and extending in the predetermined direction. The first power supply wire 8 and the second power supply wire 9 may be located across the first area S1 with the second power supply wire 9 located nearer the second area S2 than the first power supply wire 8. This structure includes two power supply wires each carrying a diverted power supply current. Thus, a power supply voltage is less likely to drop in the wiring direction. The first power supply wire 8 and the second power supply wire 9 may share a single input end and a single output end. This structure allows input of a predetermined power supply current into the single input end of the first power supply wire 8 and the second power supply wire 9 to automatically divert the current. This structure also simplifies the wiring structure that connects the first power supply wire 8 and the second power supply wire 9. The second power supply wire 9 is located nearer the second area S2 than the first power supply wire 8. Thus, a wire connecting the source electrode of each TFT 44a and the second power supply wire 9 is shorter, and a wire connecting the source electrode of each TFT 44b and the second power supply wire 9 is shorter.

The light-emitting device may include connection wiring located on the substrate 31 and extending in the intersecting direction to connect the first power supply wire 8 and the second power supply wire 9. This structure includes power supply wiring including the first power supply wire 8, the second power supply wire 9, and the connection wiring, increasing the cross-sectional area of the power supply wiring and decreasing resistance of the power supply wiring. Thus, the power supply wiring may have a smaller voltage drop. The multiple light-emitting portions aligned in the direction of wires of the power supply wiring are less likely to have gradient luminance when the same amount of driving current is input.

The connection wiring may include a first connection wire 11 and a second connection wire 12. Thus, the power supply wiring has a larger cross-sectional area and smaller resistance. This further reduces a voltage drop in the power supply wiring. The multiple light-emitting portions aligned in the direction of wires of the power supply wiring are further less likely to have gradient luminance when the same amount of driving current is input. The connection wiring may include one or more connection wires other than the first connection wire 11 and the second connection wire 12. In other words, the connection wiring may include three or more wires.

The first power supply wire 8 may have a greater width than the first connection wire 11 and the second connection wire 12, and the second power supply wire 9 may have a greater width than the first connection wire 11 and the second connection wire 12. Thus, the first power supply wire 8 and the second power supply wire 9, or main power supply wires, have a smaller voltage drop. This structure can further reduce the multiple light-emitting portions aligned in the direction of wires of the power supply wiring having gradient luminance when the same amount of driving current is input.

The first power supply wire 8 may have a greater width than the second power supply wire 9. This structure can reduce the voltage drop due to the first power supply wire 8 located farther from a light-emitting area (the second area S2) including the TFTs 44a, the first light-emitting portions 33L1, the TFT 44b, and the second light-emitting portion 33L2 than the second power supply wire 9. In other words, a signal path (a first signal path) between the first power supply wire 8 and the second power supply wire 9 is longer than a signal path (a second signal path) between the second power supply wire 9 and the light-emitting area. Thus, when the first power supply wire 8 has the same width as the second power supply wire 9, the first signal path has a greater voltage drop than the second signal path. With the first power supply wire 8 having a greater width than the second power supply wire 9, the first signal path has a smaller voltage drop. The voltage drop in the first signal path is closer to or the same as the voltage drop in the second signal path. Thus, the entire power supply wiring including the first power supply wire 8 and the second power supply wire 9 has a smaller voltage drop.

The first power supply wire 8 may have an increased width from the end for inputting a power supply voltage (e.g., one end of the first power supply wire 8 illustrated in FIG. 1) to the other end for outputting a power supply voltage (e.g., the other end of the first power supply wire 8 illustrated in FIG. 1). This structure may have a smaller voltage drop over the direction in which the first power supply wire 8 extends (direction of wires). The width of the first power supply wire 8 may be increased gradually or in a stepwise manner. The same or similar structure applies to the second power supply wire 9.

The first connection wire 11 and the second connection wire 12 each include a portion above the first signal wires 37d1 and the second signal wire 37d2. The portion may have a smaller width than a portion between a first signal wire 37dl of the first signal wires 37dl and the second power supply wire 9. This structure can reduce the parasitic capacitance in overlapping portions of the first connection wire 11 and the first signal wires 37d1 in a plan view and the parasitic capacitance in an overlapping portion of the first connection wire 11 and the second signal wire 37d2 in a plan view. The second connection wire 12 also produces the same or similar effects. The first connection wire 11 and the second connection wire 12 each include the portion between the first signal wire 37d1 and the second power supply wire 9 overlapping neither the first signal wires 37d1 nor the second signal wire 37d2. Thus, each portion of the first connection wire 11 and the second connection wire 12 may have a greater width. This reduces an increase in resistance in the first connection wire 11 and in the second connection wire 12.

The first connection wire 11 and the second connection wire 12 may each include a portion above the first signal wires 37d1 and the second signal wire 37d2 with a constant width. This structure allows the first connection wire 11 to have a constant parasitic capacitance in the overlapping portions of the first signal wires 37d1 and the second signal wire 37d2 in a plan view, minimizing the total parasitic capacitance.

The input of each TFT 44a may be a gate electrode. The input of the TFT 44b may be a gate electrode. The source electrode of each TFT 44a and the source electrode of the TFT 44b may be each connected to the second power supply wire 9. This structure includes shorter wires for connecting the source electrode of each TFT 44a and the second power supply wire 9 and for connecting the source electrode of the TFT 44b and the second power supply wire 9. The wires thus have less resistance, and the first light-emitting portions 33L1 and the second light-emitting portion 33L2 are less likely to have lower luminance due to the resistance of the wires.

The first connection pads 23a may extend along the first signal wires 37d1. The second connection pad 23b may extend along the second signal wire 37d2. The first connection pads 23a thus have less connection resistance, and the parasitic capacitance of each first connection wire 21 is less likely to weaken or decrease a signal voltage. The second connection pad 23b also has less connection resistance, and the parasitic capacitance of the second lead wire 22 is less likely to weaken or decrease a signal voltage. Each first connection pad 23a includes a connector such as a contact hole connected to the corresponding first signal wire 37d1. Each first connection pad 23a may easily include a connector elongated in the direction in which the first connection pad 23a extends. The first connection pad 23a may also include multiple connectors easily. These structures reduce connection resistance between each first connection pad 23a and the corresponding first signal wire 37d1. The same or similar structure applies to the second connection pad 23b and the second signal wire 37d2.

In the present embodiment, the light-emitting device includes a multilayer stacked wiring structure with various wires between multiple insulating layers on the substrate 31. The multilayer stacked wiring structure will be described. In the present embodiment, the light-emitting device includes the substrate 31 of a light-transmissive elongated plate such as a glass substrate, the first power supply wire 8 located on the substrate 31 and extending parallel to the longitudinal direction X of the substrate 31, the second power supply wire 9 located on the substrate 31 and extending parallel to the first power supply wire 8, the multiple (eight in the present embodiment) first signal wires 37d1 located in the first area S1, which is between the first power supply wire 8 and the second power supply wire 9 on the substrate 31 and parallel to the first power supply wire 8, the TFTs 44a as the first switching elements for driving. The TFTs 44a are located in the second area S2 opposite to the first area S1 from the second power supply wire 9 on the substrate 31, the first light-emitting portions 33L1 located in the second area S2 on the substrate 31 and connected to the TFTs 44a in series, and the TFT 44b as the second switching element for driving located in the second area S2 on the substrate 31 and adjacent to the TFTs 44a in the longitudinal direction X.

The light-emitting device further includes the second light-emitting portion 33L2 located in the second area S2 on the substrate 31 and connected to the TFT 44b in series, the second signal wire 37d2 located between the first signal wires 37d1 and the first power supply wire 8 in the first area S1 on the substrate 31, the first connection wire 11 connecting the first power supply wire 8 and the second power supply wire 9, the first lead wires 21 located on the substrate 31 and adjacent to the first connection wire 11 in the longitudinal direction X to connect the first signal wires 37d1 and the TFTs 44a, the second lead wire 22 located on the substrate 31 and opposite to the first lead wire 21 from the first connection wire 11 in the longitudinal direction X to connect the second signal wire 12 and the TFT 44b. The light-emitting device may further include the second connection wire 12 located on the substrate 31 and opposite to the first connection wire 11 from the second lead wire 22 in the longitudinal direction X to connect the first power supply wire 8 and the second power supply wire 9.

In the light-emitting device, the multiple first lead wires 21 are located parallel to one another. Each first lead wire 21 includes the first connection pad 23a as the first connection at the end connected to the corresponding first signal wire 37d1, and the second lead wire 22 includes the second connection pad 23b as the second connection at the end connected to the second signal wire 37d2. The distance between the second connection pad 23b and its adjacent first connection pad 23 a is greater than the distance between adjacent ones of the first connection pads 23a.

The above structure produces the effects described below. The second connection pad 23b and its adjacent first connection pad 23a define the space (space Ss12) larger than the space (Ss11) between adjacent ones of the first connection pads. This effectively reduces the likelihood that the first connection wire 11 and the second connection wire 12 as the power supply branch wires located through the space Ss12 comes into contact with the first lead wires 21 and the second lead wire 22 as the upper-layer gate potential supply wires and are short-circuited. The first connection wire 11 and the second connection wire 12 as the power supply branch wires may each maintain a greater width. Thus, a sufficient power supply voltage (source voltage) may be fed to the drive TFTs 44a as the first switching elements and the drive TFT 44b as the second switching element. The distance between the second connection pad 23b and its adjacent first connection pad 23a is greater than the distance between adjacent ones of the first connection pads 23a. Thus, the second lead wire 22 may have a greatly different length from the first lead wires 21. In this structure, the second lead wire 22 has a greatly different parasitic capacitance from the first lead wires 21. Thus, the multiple light-emitting portions are less likely to have luminance with gradient variations in the longitudinal direction. This structure can eliminate the gradient distributions of parasitic capacitance of each wire located in the direction of the aligned light emitters, allowing the light-emitting device to have less varied luminance.

The first lead wire 21 and the first connection wire 11 are spaced at least by a first distance ΔL1 apart in the longitudinal direction X. The second lead wire 22 and the first connection wire 11 may be spaced by a second distance ΔL2 apart, which is greater than or equal to the first distance ΔL1 in the longitudinal direction X. The second lead wire 22 and the second connection wire 12 are spaced by a third distance ΔL3 apart, which is greater than or equal to the first distance ΔL1 in the longitudinal direction. Although the second lead wire 22 may come into contact with the adjacent first connection wire 11 and second connection wire 12, at least one of the first connection wire 11 or the second connection wire 12 may be less likely to come into contact with the second lead wire 22. The first distance ΔL1 may be, for example, 3 to 20 µm. The second distance ΔL2 may be, for example, 3 to 20 µm. The third distance ΔL3 may be, for example, 3 to 20 µm.

The first connection wire 11 and the second connection wire 12 each have a width W1 in portions above the first signal wires 37d1 and the second signal wire 37d2, and a width W2 in a portion between a first signal wire 37d1 of the first signal wires 37d1 and the second power supply wire 9. The W1 may be smaller than the W2 (W1 < W2). This structure can reduce the parasitic capacitance in overlapping portions of the first connection wire 11 and the first signal wires 37d1 in a plan view and the parasitic capacitance in an overlapping portion of the first connection wire 11 and the second signal wire 37d2 in a plan view. The second connection wire 12 also produces the same or similar effects.

The first connection pads 23a may extend along the first signal wires 37d1. The second connection pad 23b may extend along the second signal wire 37d2. The first connection pads 23a thus have less connection resistance, and the parasitic capacitance of each first connection wire 21 is less likely to weaken or decrease a signal voltage. The second connection pad 23b also has less connection resistance, and the parasitic capacitance of the second lead wire 22 is less likely to weaken or decrease a signal voltage.

The first connection wire 11 and the second connection wire 12 may each have a constant width in areas in which the first signal wires 37d1 and the second signal wire 37d2 are located on the substrate 31 in a plan view. This structure allows the first connection wire 11 to have a constant parasitic capacitance in the overlapping portions of the first signal wires 37d1 and the second signal wire 37d2 in a plan view, minimizing the total parasitic capacitance.

The first connection wire 11 and the second connection wire 12 may each have the width (W1 in FIG. 1) that is the same as the dimension of each first connection pad 23a in the longitudinal direction. The first connection wire 11 and the second connection wire 12 may each maintain a greater width W1, further allowing a sufficient power supply voltage (source voltage) to be fed to the TFTs 44a and the TFT 44b. More specifically, when the length LS1 (W3 in FIG. 1) of each first connection pad 23a in the longitudinal direction is the same as the length LS2 (W4 in FIG. 1) of the second connection pad 23b in the longitudinal direction, the width W1 for each of the first connection wire 11 and the second connection wire 12 is the same as the length LS1 (W3) or the length LS2 (W4). When the length LS1 (W3) is different from the length LS2 (W4), the width W1 for each of the first connection wire 11 and the second connection wire 12 may be the same as the shorter one of the length LS 1 (W3) or the length LS2 (W4).

When W3 and W4 are the same, for example, W1 is about 95 to 105% inclusive of W3 or W4. When W3 and W4 are different, or for example, W3 < W4, W1 is about 95 to 105% inclusive of W3. The width W1 is about 20 to 100 µm, for example. The width W3 (= W4) is about 20 to 100 µm.

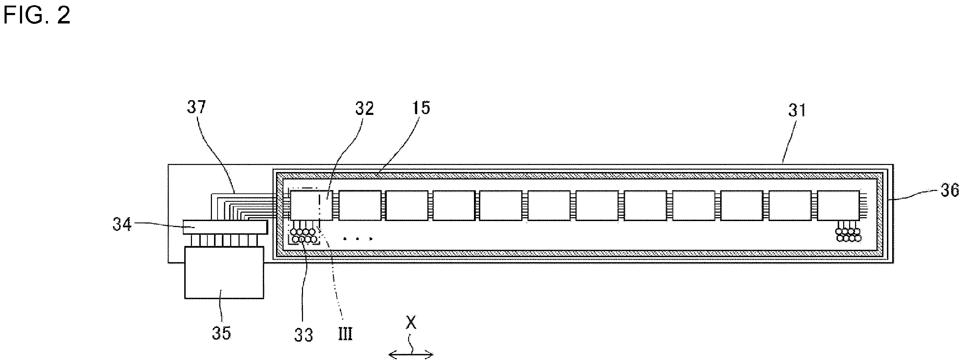

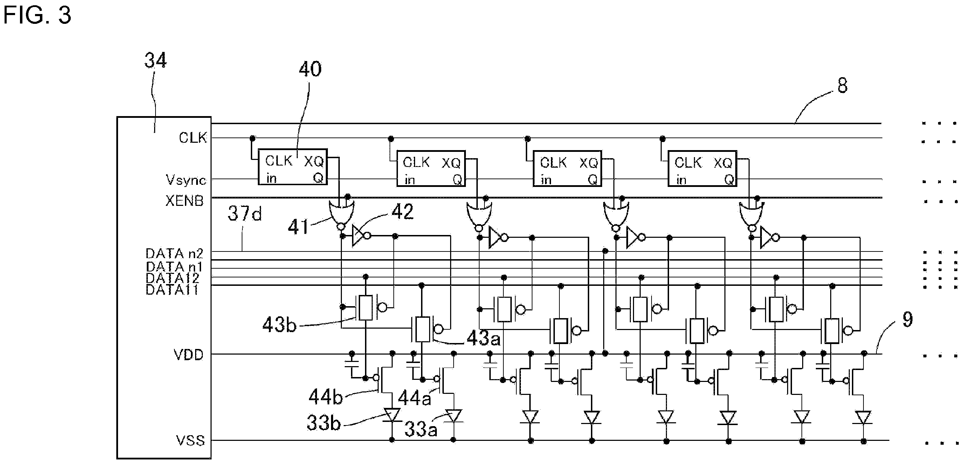

FIG. 2 is a schematic plan view of the light-emitting device illustrating its overall structure. FIG. 3 is an enlarged circuit diagram illustrating part III in FIG. 2 and a driver 34. The light-emitting device includes, on one surface of the substrate 31, the multiple drive circuit blocks 32 each for driving multiple light emitters 33 and the multiple light emitters 33 aligned in two lines in the longitudinal direction X of the substrate 31. The substrate 31 includes, on one surface, wires in the drive circuit blocks 32 and wires for connecting the drive circuit blocks 32 and the light emitters 33 formed with a thin film formation method such as chemical vapor deposition (CVD).

The multiple drive circuit blocks 32 are arrayed along the multiple light emitters 33 in line. In an example structure in which a single drive circuit block 32 drives 400 light emitters 33, 20 drive circuit blocks 32 are aligned. Thus, the light-emitting device include 8000 light emitters 33 in total. The substrate 31 includes, on one end of the surface, the driver 34 for driving the drive circuit blocks 32 and the light emitters 33 and controlling illumination of the light emitters 33 that are mounted with a mounting method such as COG. An FPC 35 is connected to a periphery near the installation position of the driver 34 on the surface of the substrate 31. The FPC 35 and the driver 34 input and output drive signals and control signals between them. The wires such as data wires connecting the driver 34 and the drive circuit blocks 32 are illustrated collectively with the reference numeral 37 in FIGs. 2 and 3.

As illustrated in FIG. 2, one drive circuit set drives a pair of light emitters 33a and 33b aligned in two lines. The drive circuit set includes a shift register 40, a NOR circuit 41, an inverter 42, CMOS transfer gates 43a and 43b, and the TFTs 44a and 44b for driving. The TFTs 44a and 44b each include the drain electrode connected to the corresponding light emitters 33a and 33b including, for example, LEDs.

The drive circuit set operates sequentially as described below. Upon receiving a high-level (one) clock signal (CLK) at its clock terminal (CLK) and a high-level synchronization signal (Vsync) at its input terminal (in), the shift register 40 outputs a high-level signal from its output terminal (Q) and a low-level (zero) signal from its inverting output terminal (XQ). The NOR circuit 41 receives the low-level signal from the inverting output terminal (XQ) and a low-level inverting enable signal (XENB), and then outputs a high-level signal.

Subsequently, the inverter 42 outputs a low-level signal. The CMOS transfer gate 43a then receives the high-level signal from the NOR circuit 41 at the gate electrode of its n-type MOS transistor and the low-level signal from the inverter 42 at the gate electrode of its p-type MOS transistor to be turned on, and outputs a data signal (DATA11). The data signal (DATA11) is input into the gate electrode of the TFT 44a, thus turning on the TFT 44a. A power supply current corresponding to the data signal (DATA11) is supplied to the light emitter 33a from the power supply voltage (VDD). At the same time, the CMOS transfer gate 43b receives the high-level signal from the NOR circuit 41 at the gate electrode of its n-type MOS transistor and the low-level signal from the inverter 42 at the gate electrode of its p-type MOS transistor to be turned on, and outputs a data signal (DATA12).

The data signal (DATA12) is then input into the gate electrode of the TFT 44b, turning on the TFT 44b. A power supply current corresponding to the data signal (DATA12) is supplied to the light emitter 33b from the power supply voltage (VDD). The above sequence of operations is performed in order by subsequent drive circuits, causing all the light emitters 33 to sequentially emit light.

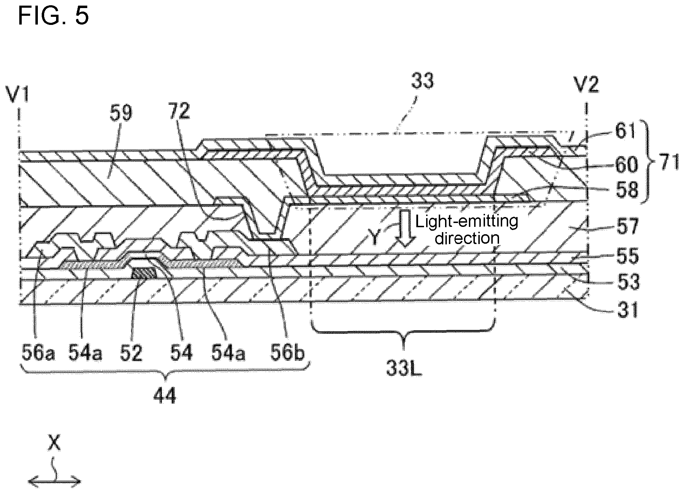

A seal 15 bonds and seals the periphery of the surface of the substrate 31 on which the light emitters are mounted and the periphery of the surface of a sealing substrate 36 facing the substrate 31. In the space inside the seal 15, an insulating layer (corresponding to an insulating layer 59 in FIG. 5) of an acrylic resin or another material is located to cover most of the drive circuit blocks 32 and the wires 37.

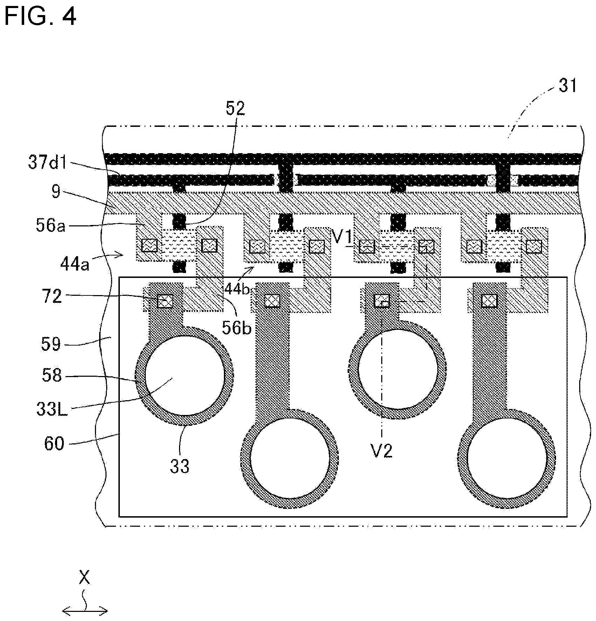

FIG. 4 is an enlarged partial plan view illustrating the enlarged light-emitting portions in FIG. 2. FIG. 5 is a cross-sectional view taken along line VI-V2 in FIG. 4. As illustrated in these figures, the light-emitting device includes the TFTs 44a and 44b on the light-transmissive substrate 31 such as a glass substrate, organic emissive portions 71 stacked on the TFTs 44a and 44b with an insulating layer 57 of an acrylic resin, silicon nitride (SiNx), or another material between them, and contact holes 72 electrically connecting the organic emissive portions 71 and drain electrodes 56b of the TFTs 44. Each organic emissive portion 71 includes a first electrode layer 58 electrically connected to the corresponding contact hole 72, an organic emissive layer 60, and a second electrode layer 61 stacked from the portion near the corresponding TFT 44. Another insulating layer 59 of an acrylic resin or another material is located on the insulating layer 57 and the first electrode layer 58 to surround the organic emissive layer 60.

In FIGs. 4 and 5, a light-emitting portion 33L emits light when the first electrode layer 58 and the second electrode layer 61 apply a magnetic field directly to the organic emissive layer 60. The light emitter 33 includes the light-emitting portion 33L, and the first electrode layer 58 and the organic emissive layer 60 around the light-emitting portion 33L in a plan view. When the first electrode layer 58 is the anode being a transparent electrode of, for example, indium tin oxide (ITO) and the second electrode layer 61 is the cathode of a metal or an alloy, such as Al, an Al-Li alloy, a Mg-Ag alloy (including about 5 to 10 wt% of Ag), or Mg-Cu alloy (including 5 to 10 wt% of Cu), with a low work function of about 4.0 V or lower and light-shielding and light-reflecting properties, the light emitted at the organic emissive layer 60 is emitted through the substrate 31. In other words, the light-emitting direction Y is downward, and the light-emitting device is a bottom-emission device.

When the first electrode layer 58 is the cathode of a metal having the light-shielding and light-reflecting properties or an alloy of such metals and the second electrode layer 61 is the anode being a transparent electrode, the light-emitting direction Y is upward and the light-emitting device is a top-emission device.

Each of the TFTs 44a and 44b (referred to collectively without lower-case letters a or b) include, from the portion near the substrate 31, a gate electrode 52, a gate insulating film 53, a semiconductor film of a polysilicon film 54 as a channel and a high-concentration impurity area 54a of polysilicon including higher concentration of impurities than the channel, an insulating film 55 of silicon nitride (SiNx), silicon oxide (SiO₂), or another material, a source electrode 56a, and the drain electrode 56b stacked one another in this order.

In FIG. 4, the second power supply wire 9 is a source signal wire (power supply wire) that carries a source signal (power supply current) to each source electrode 56a. The first signal wire 37d1 is a gate signal wire that carries a gate signal to each gate electrode 52. The voltage of the gate signals to be input into the corresponding first signal wire 37d1 as a gate signal wire is controlled to control the intensity of light emitted from the corresponding organic emissive layer 60. In other words, the second power supply wire 9 functions as a power supply wire (source signal wire).

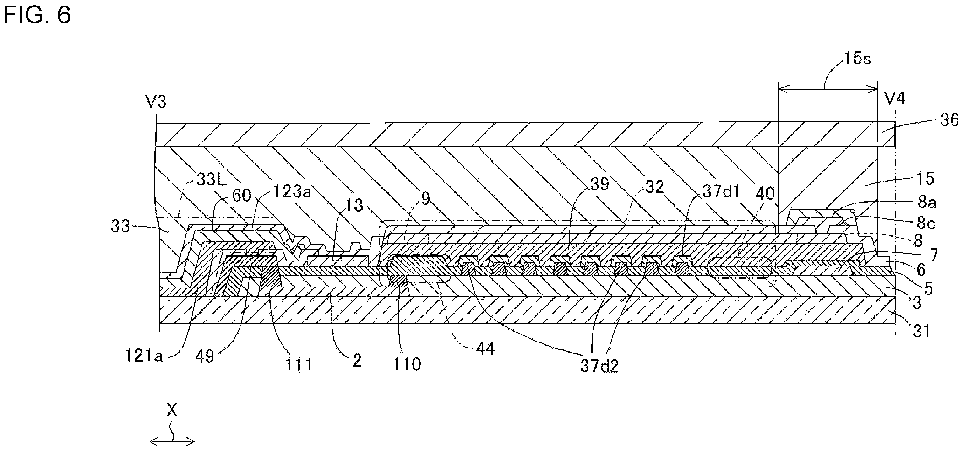

FIG. 6 is a cross-sectional view taken along line V3-V4 in FIG. 1. The surface of the substrate 31 on which the light emitters 33 are mounted includes an anode connection wire 2 electrically connecting the drain electrode of each TFT 44 and a first electrode layer (anode electrode in the example illustrated in FIG. 6) 121a of each light-emitting portion 33L, and a first interlayer insulating film 3 of SiNₓ, SiO₂, or another material above the anode connection wire 2 in this order.

The first interlayer insulating film 3 on which the wires 37d such as data wires for supplying a drive current to the organic emissive layer 60 and a ground wire 7 are located is covered with a second interlayer insulating film 5 of SiNₓ, SiO₂, or another material. An insulating layer 39 (corresponding to the insulating layer 59 in FIG. 5) is located on the second interlayer insulating film 5 to cover the ground wire 7, the wires 37d, and the TFT 44.

The first power supply wire 8 as an anode power supply wire is located on the insulating layer 39. An anode wire 9 carrying an anode current to the source electrode of the TFT 44 is located in an area on the insulating layer 39 overlapping the TFT 44 in a plan view. A protective insulating layer 6 is of SiNx, SiO₂, or another material covering the first power supply wire 8 and the anode wire 9. The component 32 is the drive circuit block, and the component 40 is the shift register.

The seal 15 is located on the protective insulating layer 6 in the overlapping portion of the first power supply wire 8 in a plan view. The seal 15 hermetically seals the substrate 31 and the sealing substrate 36.

A cathode power supply wire 13 is located in the area on the second interlayer insulating film 5 overlapping the anode connection wire 2. An interlayer conductor layer 49 is located near the light emitter 33 to connect the anode connection wire 2 and the first electrode layer 121a. The anode connection wire 2 includes one end near the TFT 44 including a first contact hole 110 connected to the source electrode of the TFT 44, and the other end near the light emitter 33 including a second contact hole 111 connected to the interlayer conductor layer 49.

The first electrode layer 21a covers an end of the protective insulating layer 6 adjacent to the light-emitting portion 33L. The organic emissive layer 60 is located on the first electrode layer 21a. A second electrode layer (cathode electrode in FIG. 6) 123a covers the organic emissive layer 60. The second electrode layer 123a has an end connected to the cathode power supply wire 13.

On the first power supply wire 8, an auxiliary power supply wire (also referred to as a power supply increasing wire) 8a is located parallel to the first power supply wire 8. The first power supply wire 8 and the auxiliary power supply wire 8a are connected through a contact hole 8c. This structure substantially increases the cross-sectional area of the first power supply wire 8, reducing resistance of the first power supply wire 8. Thus, the first power supply wire 8 shaped in a strip or a line in the longitudinal direction of the substrate 31 being an elongated plate has a smaller voltage drop.

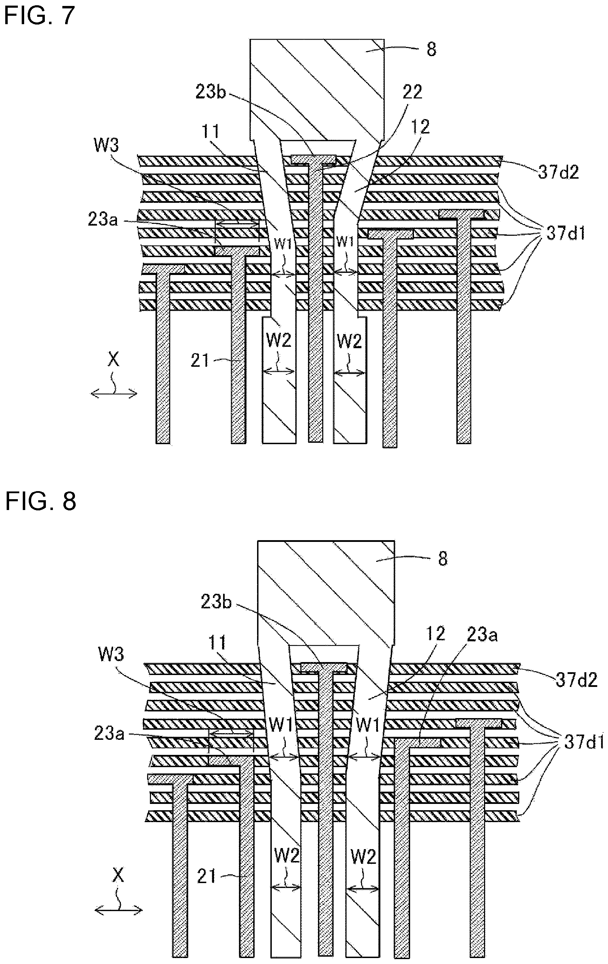

As described above and illustrated in an enlarged partial plan view in FIG. 7, the light-emitting device in the present embodiment includes, in a plan view, T-shaped first and second connection pads 23a and 23b at the ends of the first lead wires 21 and the second lead wire 22. The first and second connection pads 23a and 23b are each connected to either the corresponding first signal wire 37d1 or the second signal wire 37d2. The light-emitting device also has a wiring pattern in which the first power supply wire 8 is connected to the second power supply wire 9 with the first connection wire 11 and the second connection wire 12. The first connection wire 11 and a first lead wire 21 are spaced by the first distance ΔL1 apart in the longitudinal direction X, and the first connection wire 11 and the second lead wire 22 are spaced by the second distance ΔL2 apart in the longitudinal direction X. Thus, the first connection wire 11 and the first lead wire 21 may maintain an insulation distance between them, and the first connection wire 11 and the second lead wire 22 may maintain an insulation distance between them. This structure can supply power to the many light emitters 33 aligned in arrays in the longitudinal direction of the substrate 31 without a decrease in the cathode potential as a power supply voltage. The same or similar structure applies to the second connection wire 12.

The second distance ΔL2 between the first connection wire 11 and the second lead wire 22 in the longitudinal direction X is greater than or equal to the first distance ΔL1 between the first connection wire 11 and the first lead wire 21 in the longitudinal direction X. This structure allows the first lead wire 21 and the second lead wire 22 to be located at constant intervals in the longitudinal direction X, thus allowing a denser wiring pattern.

The first and the second lead wires 21 and 22 each have the width W3 in the longitudinal direction X. The first and the second connection wires 11 and 12 each include a portion above the first and the second signal wires 37d1 and 37d2 having the width W1 in the longitudinal direction X, and the portion between a first signal wire 37d1 of the first signal wires 37d1 and the second power supply wire 9 having the width W2. Setting the width W1 shorter than the width W2 provides insulation distances between the first connection wire 11 and the first lead wire 21 and between the first connection wire 11 and the second lead wire 22 as described above. Thus, the first power supply wire 8 and the second power supply wire 9 may be connected electrically to eliminate gradient parasitic capacitance in each wire 37 along the aligned light emitters 33. This structure can provide a light-emitting device with less varied luminance of emitted light.

### Second Embodiment

FIG. 8 is a plan view of a light-emitting device according to another embodiment of the present disclosure illustrating its wiring structure. The components corresponding to those in the above embodiments are given like reference numerals and will not be described repeatedly. In the present embodiment, the light-emitting device includes the first lead wires 21 with the first connection pads 23a. Each first connection pad 23a extends toward the direction (the left in FIG. 8) far from the first connection wire 11 in the longitudinal direction X and has the width W3. The first connection pads 23a is in the shape of inverted L in a plan view.

Thus, the first connection wire 11 may have the width W1 in the portions above the first signal wires 37d1 and the second signal wire 37d2 same as the width W2 in the portion located between a first signal wire 37d1 of the first signal wires 37d1 and the second power supply wire 9.

### Third Embodiment

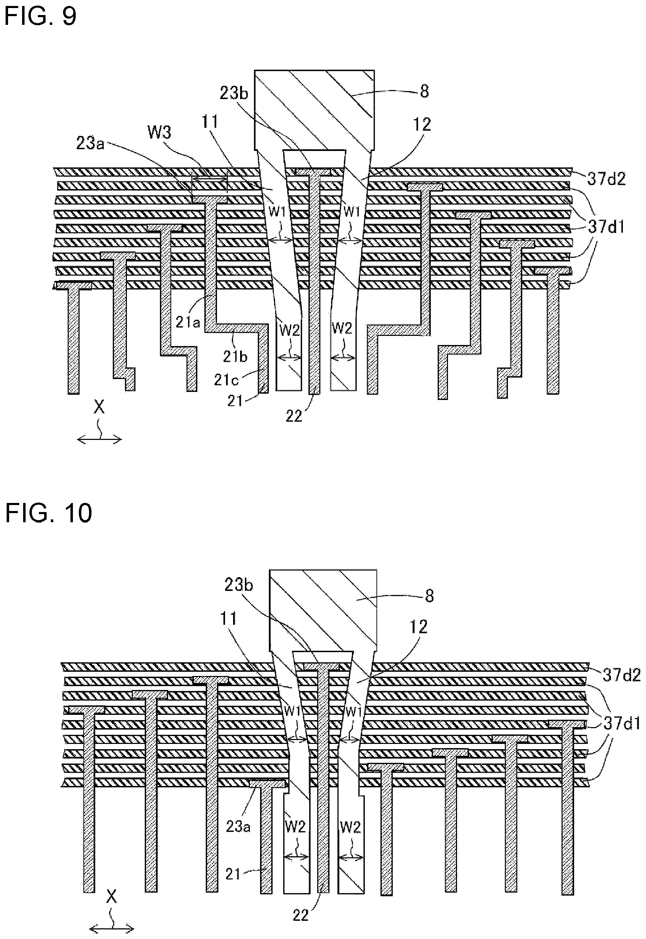

FIG. 9 is a plan view of a light-emitting device according to another embodiment of the present disclosure illustrating its wiring structure. The components corresponding to those in the above embodiments are given like reference numerals and will not be described repeatedly. In the present embodiment, the light-emitting device includes the first lead wires 21 each including a first portion 21a extending from the first signal wire 37d1 toward the second power supply wire 9 in the direction Y perpendicular to the longitudinal direction X, a second portion 21b extending orthogonally from the end of the first portion 21a nearest the second power supply wire 9 toward the first connection wire 11, and a third portion 21c turning orthogonally at the end of the second portion 21b nearest the first connection wire 11 to extend toward the second power supply wire 9.

This structure allows the first connection wire 11 and a first lead wire 21 to be spaced apart in the longitudinal direction X, greatly separating the first lead wire 21 above the first and the second signal wires 37d1 and 37d2 from the first connection wire 11.

### Fourth Embodiment

FIG. 10 is a plan view of a light-emitting device according to another embodiment of the present disclosure illustrating its wiring structure. The components corresponding to those in the above embodiments are given like reference numerals and will not be described repeatedly. In the light-emitting device in the present embodiment, a first lead wire 21 adjacent to the first connection wire 11 is connected to a first signal wire 37d1 nearest the second power supply wire 9 with the corresponding first connection pad 23a. This structure maximizes the space between the second connection pad 23b and the first connection pad 23a adjacent to the second connection pad 23b.

In the embodiments described above, the multiple light-emitting portions including the first light-emitting portions 33L1 and the second light-emitting portion 33L2 are aligned in line at equal intervals of 20 to 40 µm inclusive in the longitudinal direction X to be a light-emitting array, and two of the light-emitting arrays are arranged. In other embodiments of the present disclosure, the multiple light-emitting portions may be arranged in four lines of light-emitting arrays extending in the longitudinal direction X. The multiple light-emitting portions including the first light-emitting portions 33L1 and the second light-emitting portion 33L2 may be arranged in lines in the longitudinal direction X at equal intervals of 10 to 60 µm inclusive to be a light-emitting array. Two, four, or six of the light-emitting arrays may be arranged in lines.

In one or more embodiments of the present disclosure, the light-emitting device has the distance between the second connection and the first connection adjacent to the second connection being greater than the distance between adjacent ones of the first connections. Thus, the space (space Ss12) between the second connection and its adjacent first connection is larger than the space (space Ss11) between the adjacent ones of the first connections. In other words, another wire such as a power supply branch wire can be placed through the space Ss12 more easily when Ss12 > Ss11. This allows complex wiring structure in a space with a limited area. This also allows the other wire such as a power supply branch wire located through the space Ss12 to have a greater width, thus lowering the resistance of the other wire.

In one or more embodiments of the present disclosure, the light-emitting device achieves Ss12 > Ss11 as described above. Thus, the first connection wire as a power supply branch wire located through the space Ss12 is less likely to come into contact with the first and the second lead wires as upper-layer gate potential supply wires, thus effectively reducing short-circuiting. Each first connection wire as a power supply branch wire may maintain a greater width. Thus, a sufficient power supply voltage (source voltage) may be fed to the first switching elements and the second switching element as drive TFTs. The distance between the second connection and its adjacent first connection is greater than the distance between adjacent ones of the first connections. Thus, the second lead wire may have a greatly different length from each first lead wire. In this structure, the second lead wire has a greatly different parasitic capacitance from each first lead wire. Thus, the multiple light-emitting portions are less likely to have luminance with gradient variations in the longitudinal direction. This structure can eliminate the gradient distributions of parasitic capacitance of each wire in the direction of the aligned light emitters, and allows a light-emitting device to have less varied luminance.

Although the embodiments of the present disclosure have been described in detail, the present disclosure is not limited to the embodiments described above, and may be changed or modified in various manners without departing from the spirit and scope of the present disclosure. The components described in the above embodiments may be entirely or partially combined as appropriate unless any contradiction arises.

### INDUSTRIAL APPLICABILITY

In one or more embodiments of the present disclosure, the light-emitting device may be an OLEDP head being an elongated plate with, for example, the multiple light-emitting portions aligned in line in the longitudinal direction of the substrate 31. The light-emitting device may be an organic electroluminescence (EL) display device with the multiple light-emitting portions arranged in two-dimensional (planar) manner on a substrate as an elongate plate or with another shape. In one or more embodiments of the present disclosure, the light-emitting device and the organic EL display device may be used for various electronic devices. Such electronic devices include lighting apparatus, automobile route guidance systems (car navigation systems), ship route guidance systems, aircraft route guidance systems, indicators for instruments in vehicles such as automobiles, instrument panels, smartphones, mobile phones, tablets, personal digital assistants (PDAs), video cameras, digital still cameras, electronic organizers, electronic books, electronic dictionaries, personal computers, copiers, terminals for game devices, television sets, product display tags, price display tags, programmable display devices for industrial use, car audio systems, digital audio players, facsimile machines, printers, automatic teller machines (ATMs), vending machines, medical display devices, digital display watches, and smartwatches.

### REFERENCE SIGNS

- 2: anode connection wire
- 3: interlayer insulating film
- 5: interlayer insulating film
- 6: protective insulating layer
- 7: ground wire
- 8: first power supply wire
- 8a: auxiliary power supply wire
- 9: second power supply wire
- 11: first connection wire
- 12: second connection wire
- 21: first lead wire
- 22: second lead wire
- 23a: first connection pad
- 23b: second connection pad
- 31: substrate
- 32: drive circuit block
- 33L1: first light-emitting portion
- 33L2: second light-emitting portion
- 36: sealing substrate
- 37d1: first signal wire
- 37d2: second signal wire
- 40: shift register
- 44a, 44b: thin-film transistor
- 52: gate electrode
- 53: gate insulating film
- 54: polysilicon film
- 55: insulating film
- 56a: source electrode
- 56b: drain electrode
- 57: insulating layer
- 58: first electrode layer
- 59: insulating layer
- 60: organic emissive layer
- 61: second electrode layer
- 71: organic emissive portion
- 72: contact hole
- S1: first area
- S2: second area
- X: longitudinal direction
- Y: light-emitting direction
- W1, W2, W3: width

## Claims

1. A light-emitting device, comprising:
a substrate;
a plurality of first signal wires and a second signal wire located in a first area on the substrate and extending in a predetermined direction;
a plurality of first switching elements and a plurality of first light-emitting portions connected to outputs of the plurality of first switching elements, the plurality of first switching elements and the plurality of first light-emitting portions being located in a second area on the substrate;
a second switching element and a second light-emitting portion connected to an output of the second switching element, the second switching element and the second light-emitting portion being located in the second area and adjacent to a first switching element of the plurality of first switching elements and a first light-emitting portion of the plurality of first light-emitting portions in the predetermined direction;
a plurality of first lead wires connected to inputs of the plurality of first switching elements, the plurality of first lead wires extending in a direction intersecting with the predetermined direction;
a second lead wire connected to an input of the second switching element, the second lead wire extending in a direction intersecting with the predetermined direction;
a plurality of first connections of the plurality of first lead wires, the plurality of first connections being connected to the plurality of first signal wires; and
a second connection of the second lead wire, the second connection being connected to the second signal wire,
wherein a distance between the second connection and a first connection of the plurality of first connections adjacent to the second connection is greater than a distance between adjacent first connections of the plurality of first connections.

2. The light-emitting device according to claim 1, wherein
the second signal wire is located farther from the second area than each of the plurality of first signal wires, and
the second lead wire is longer than each of the plurality of first lead wires.

3. The light-emitting device according to claim 1 or claim 2, further comprising:
a first power supply wire and a second power supply wire located on the substrate and extending in the predetermined direction,
wherein the first power supply wire and the second power supply wire are located across the first area, and
the second power supply wire is nearer the second area than the first power supply wire.

4. The light-emitting device according to claim 3, further comprising:
connection wiring located on the substrate and extending in the intersecting direction, the connection wiring connecting the first power supply wire and the second power supply wire.

5. The light-emitting device according to claim 4, wherein
the connection wiring includes a first connection wire and a second connection wire.

6. The light-emitting device according to claim 5, wherein
the first power supply wire has a greater width than the first connection wire and the second connection wire, and
the second power supply wire has a greater width than the first connection wire and the second connection wire.

7. The light-emitting device according to claim 5 or claim 6, wherein
the first connection wire and the second connection wire each have a smaller width in portions of the first connection wire and the second connection wire above the plurality of first signal wires and the second signal wire than in portions of the first connection wire and the second connection wire between a first signal wire of the plurality of first signal wires and the second power supply wire.

8. The light-emitting device according to any one of claims 5 to 7, wherein
the first connection wire and the second connection wire each have a constant width in portions of the first connection wire and the second connection wire above the plurality of first signal wires and the second signal wire.

9. The light-emitting device according to any one of claims 3 to 8, wherein
the plurality of first switching elements are first thin-film transistors including the inputs being gate electrodes,
the second switching element is a second thin-film transistor including the input being a gate electrode, and
the plurality of first thin-film transistors and the second thin-film transistor each include a source electrode connected to the second power supply wire.

10. The light-emitting device according to any one of claims 1 to 9, wherein
the plurality of first connections extend along the plurality of first signal wires, and
the second connection extends along the second signal wire.

11. A light-emitting device, comprising:
a substrate being an elongated plate;
a first power supply wire located on the substrate and extending parallel to a longitudinal direction of the substrate;
a second power supply wire located on the substrate and extending parallel to the first power supply wire;
a plurality of first signal wires located in a first area between the first power supply wire and the second power supply wire on the substrate, the plurality of first signal wires extending parallel to the first power supply wire;
a plurality of first switching elements and a plurality of first light-emitting portions connected to the plurality of first switching elements, the plurality of first switching elements and the plurality of first light-emitting portions being located in a second area on the substrate, the second area being located opposite to the first area from the second power supply wire;
a second switching element and a second light-emitting portion connected to the second switching element, the second switching element and the second light-emitting portion being located in the second area and adjacent to a first switching element of the plurality of first switching elements and a first light-emitting portion of the plurality of first light-emitting portions in the longitudinal direction;
a second signal wire located between the plurality of first signal wires in the first area and the first power supply wire;
a first connection wire connecting the first power supply wire and the second power supply wire;
a plurality of first lead wires located on the substrate, the plurality of first lead wires including a first lead wire adjacent to the first connection wire in the longitudinal direction, the plurality of first lead wires connecting the plurality of first signal wires and the plurality of first switching elements; and
a second lead wire located on the substrate and opposite to the first lead wire adjacent to the first connection wire from the first connection wire in the longitudinal direction, the second lead wire connecting the second signal wire and the second switching element,
wherein the plurality of first lead wires are located parallel to one another,
the plurality of first lead wires include a plurality of first connections at ends connected to the plurality of first signal wires,
the second lead wire includes a second connection at an end connected to the second signal wire, and
a distance between the second connection and a first connection of the plurality of first connections adjacent to the second connection is greater than a distance between adjacent first connections of a plurality of the first connections.

12. The light-emitting device according to claim 11, further comprising:
a second connection wire located on the substrate and opposite to the first connection wire from the second lead wire in the longitudinal direction, the second connection wire connecting the first power supply wire and the second power supply wire,
wherein the first lead wire adjacent to the first connection wire and the first connection wire are spaced at least by a first distance apart in the longitudinal direction,
the second lead wire and the first connection wire are spaced by a second distance apart in the longitudinal direction, and the second distance is greater than or equal to the first distance, and
the second lead wire and the second connection wire are spaced by a third distance apart in the longitudinal direction, and the third distance is greater than or equal to the first distance.

13. The light-emitting device according to claim 12, wherein
the first connection wire and the second connection wire each have a smaller width in portions above the plurality of first signal wires and the second signal wire than in portions between a first signal wire of the plurality of first signal wires and the second power supply wire.

14. The light-emitting device according to any one of claims 11 to 13, wherein
the plurality of first connections extend along the plurality of first signal wires, and
the second connection extends along the second signal wire.

15. The light-emitting device according to claim 12 or claim 13, wherein
the first connection wire and the second connection wire each have a constant width in an area containing the plurality of first signal wires and the second signal wire on the substrate in a plan view.

16. The light-emitting device according to any one of claims 12, 13, and 15, wherein
the first connection wire and the second connection wire each have a width equal to a dimension of the first connection pad in the longitudinal direction.

17. The light-emitting device according to any one of claims 11 to 16, wherein
the plurality of first light-emitting portions and the second light-emitting portion are aligned in line at equal intervals of 20 to 40 µm inclusive in the longitudinal direction to be a light-emitter array, and
two or four of the light-emitter arrays are arranged in lines.
